Europäisches Patentamt

European Patent Office

Office européen des brevets

(19)

(11) Publication number: **0 040 842**
**B1**

# EUROPEAN PATENT SPECIFICATION

(12)

(45) Date of publication of patent specification: **15.08.84**

(51) Int. Cl.³: **G 03 F 7/16, G 03 C 1/74**

(21) Application number: **81103965.0**

(22) Date of filing: **23.05.81**

(54) Laminating process.

(30) Priority: **27.05.80 US 153637**

(43) Date of publication of application:
**02.12.81 Bulletin 81/48**

(45) Publication of the grant of the patent:
**15.08.84 Bulletin 84/33**

(84) Designated Contracting States:
**AT BE CH DE FR GB IT LI LU NL SE**

(56) References cited:

**NONE**

(73) Proprietor: **E.I. DU PONT DE NEMOURS AND COMPANY**
**Legal Department 1007 Market Street**
**Wilmington Delaware 19898 (US)**

(72) Inventor: **Weiner, Jerold Samuel**
**R.D. 2 Box 280-1**
**Blairstown New Jersey 07825 (US)**
Inventor: **Small, Samuel**
**920 Val Park Avenue**
**Valley Stream New York 11580 (US)**

(74) Representative: **Werner, Hans-Karsten, Dr. et al,**
**Deichmannhaus am Hauptbahnhof**
**D-5000 Köln 1 (DE)**

Courier Press, Leamington Spa, England.

**Description**

Technical field

The invention relates to a process for laminating film-forming thermoplastic polymers to a substrate. The invention particularly relates to a process for laminating photosensitive layers to printed circuit substrates.

Background of the invention and prior art

In the manufacture of printed circuit boards from conventional photoresist elements, it is necessary to laminate the photosensitive layer of the element to the substrate board in such manner that the layer is firmly adhered thereto without occulsions and other phase discontinuities such as entrapped air. Furthermore, in many manufacturing situations, it is also desirable that a strong adhesive bond be formed instantly so that subsequent operations can proceed.

U.S. Patent 3,547,730 discloses the lamination of photoresist layer to a substrate by passing the layer and substrate through the nip of heated spring-loaded laminating rolls. The photoresist layer and/or the substrate may be preheated prior to the lamination step. The purpose of this heating is to enable the layer to be forced into intimate contact with the substrate under the pressure of the rolls, whereby the layer achieves sufficient adhesion to the substrate to withstand subsequent photoresist processing steps such as solvent development and etching or plating of the substrate.

U.S. Patent 3,629,036 discloses the use of a solution of photoresist to coat the substrate prior to lamination with a layer of photoresist. The coating solution purportedly enables sufficient adhesion to be obtained without heating being required for lamination. The coating solution is applied for example by pressing wicks against the substrate.

Though the prior art methods of lamination are satisfactory for many applications, there is a need for even more precise and uniform lamination methods, especially where printed circuit boards having a very high line density are being fabricated.

Summary of the invention

The invention is therefore directed to a process which satisfies the need for reproducibly uniform lamination of thermoplastic polymers and particularly photosensitive layers, which can be described as follows:

In a process for laminating a supported photosensitive layer to a substrate surface by means of pressure, the improvement comprising the sequential steps of:

(a) forming a thin layer of liquid on the substrate surface immediately prior to lamination by contacting the surface at a temperature below the condensation point of the liquid with a vapor derived from the liquid or gaseous dispersion of finely divided liquid particles, which layer forms an interface between the substrate surface and the photosensitive layer upon lamination; and

(b) displacing the thin layer of liquid from the substrate surface by absorption into the photosensitive layer during lamination.

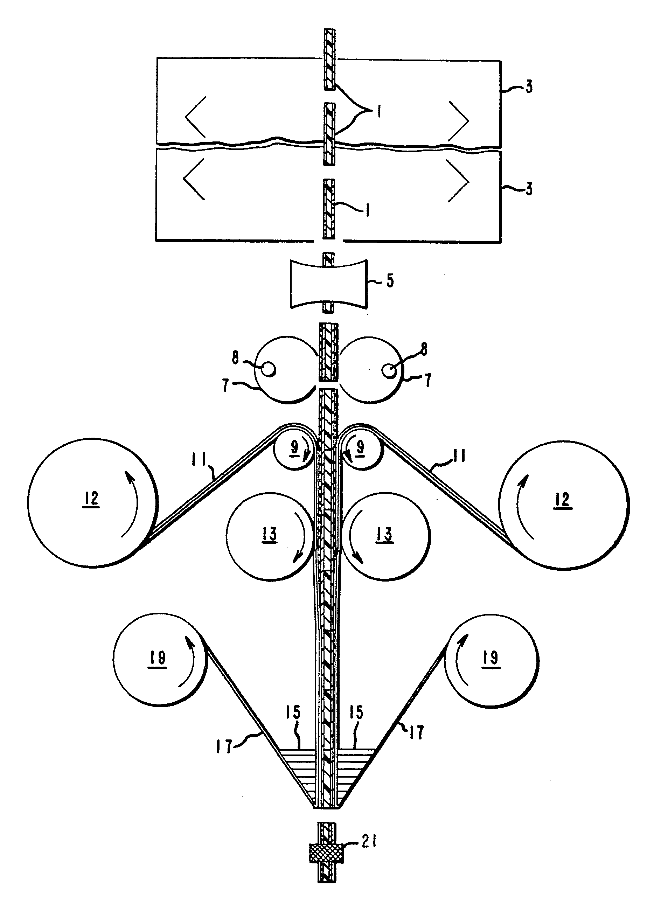

Brief description of the drawing

Further advantages and details of the invention will be apparent by reference to the Drawing which consists of a single figure which illustrates schematically a preferred application of the process of the invention in a continuous laminating process.

Detailed description of the invention

A primary goal of the invention is not only to obtain very good adhesion, but also to obtain such adhesion very rapidly, that is, with nip contact during lamination of as little as about one second and preferably even less. This goal is achieved by virtue of the facts (1) that the thin layer first prepared the surface and (2) that it is then almost instantaneously displaced from the surface primarily by absorption into the photolaye . When more volatile liquids are used to form the thin film, and especially when elevated laminating temperatures are used, the thin film may be displaced to a minor extent by evaporation as well. In any event, the rapid displacement of the thin layer from the substrate surface assures that it cannot interfere with adhesion upon that surface.

The liquids which can be used in the invention are preferably those which are capable of wetting the substrate to which the photosensitive layer is being applied. The liquids are applied immediately prior to lamination as a uniformly thin layer on the substrate surface by contacting the surface with vapor or with a gaseous dispersion of finely divided liquid particles. In the case of the vapor application, the desired film is formed by condensation on the substrate.

Proper selection of the absorptive liquid is essential to form an instantaneous and strong bond between the thermoplastic layer and a nonporous substrate since any liquid remaining at the interface will act as a release layer and substantially weaken the bond. Instant adhesion is particularly important in high productivity or on-line processes where the film support is removed from a photosensitive thermoplastic layer within 1—2 minutes (preferably 30 seconds) after lamination of this layer to a nonporous substrate. Preferably the liquid should quickly diffuse, vaporize or be absorbed into the layer. Such liquids need not be a solvent for the thermoplastic layer and, in fact, solvents can be disadvantageous since they tend to solvate, soften, distort or concentrate at the interface, giving a weaker bond than if the liquid diffused away from the interface.

The thin film should cover at least 30 percent of the substrate surface on which the polymer is to be laminated preferably as a uniform layer of minute droplets. At least 80 percent coverage is preferred and essentially complete coverage is still further preferred in the form of a continuous film.

In practice, it is preferred that the thin film be as thin as is practicable. While the particular film thickness will vary considerably, depending upon the nature of the liquid and the conditions of application, it is generally preferred that it be at least about one micrometer, the average layer thickness being about 30 $\mu$m or from about 10 to about 50 $\mu$m.

It has been found that the preferred liquid material for forming the thin films in the process is water, which is preferably applied as steam near its dew point or as a mist having very fine water particles. Even air having a very high relative humidity may be used to form the thin layer. In addition to water, other liquids which can be used alone or in mixtures include solvents for the resist, nonsolvents and swelling agents. Such liquids include alcohols such as methanol, ethanol, propanol, etc.; glycols, e.g., ethylene glycols; ethylene glycol ethers, e.g., ethoxyethanol; chlorinated solvents, e.g., 1,1,1, trichloroethane, and fluorocarbons such as trichlorotrifluorethane. Preferred mixtures include water-alcohol mixtures and alcohol-fluorocarbon mixtures.

When the liquids are applied as gaseous dispersions or mists, the liquid may be solutions containing nonvolatile components such as adhesion promoters or surfactants. The primary requirement of the nonvolatile component is that it be compatible with the resist material being adhered. Suitable solutions of adhesion promoters are heterocyclic solutions such as benzimidazoles benzotriazoles and mercapto compounds as disclosed in U.S. Patent 3,645,772.

In order for the thin layer of liquid to fall within the above-described thickness limits, it will ordinarily be preferred that the particle size of the dispersed liquid or droplets should be between about 1 and 500 $\mu$m in average diameter and preferably about 10 to 50 $\mu$m.

It is an essential aspect of the invention that the applied thin liquid film be substantially displaced from the interface between the photosensitive layer and the substrate during the subsequent laminating operations. This is done mainly by absorption into the laminated polymeric layer. As used herein, the term "absorption" is not used in the usual unit operations sense, but refers to the direct transfer of the thin liquid layer under lamination pressure from the interface between the substrate and photosensitive layer into the solid photosensitive layer in which it is diffused. The precise method by which the thin liquid film is displaced is, of course, a function of the liquid and the nature of the photosensitive layer and substrate which are used. When a more volatile liquid is used in conjunction with heated laminating rolls, liquid film displacement may take place partially by vaporization. On the other hand, using a less volatile liquid and/or cooler rolls will result in less volatilization and thus removal of the liquid film will occur to a greater extent by absorption into the laminated polymer layer. Obviously, when nonvolatile liquids are used, the removal of the liquid film takes place essentially by absorption. The precise mechanism by which the liquid film is removed is not critical so long as the liquid is compatible with the laminated photosensitive layer.

Though the invention may be used advantageously in the lamination of a broad spectrum of thermoplastic layers, the invention is particularly useful for the lamination of photosensitive resist elements to substrates which are to be used for making printed circuit boards. The invention is also useful for laminating photosensitive layers to substrates in the preparation of lithographic printing plates.

In practicing the invention, photosensitive film resist elements of various types may be used. In general photohardenable, negative-working elements are photopolymerizable elements of the type disclosed in U.S. Patent 3,469,982 and the photocrosslinkable elements of the type disclosed in U.S. Patent 3,526,504. Positive-working, resist elements may be of the photosolubilizable type, e.g., such as the o-quinone diazide elements of U.S. Patent 3,837,860, or of the photodesensitizable type, e.g., such as the bisdiazonium salts of U.S. Patent 3,778,270 or the nitroaromatic compositions of U.K. Patent 1,547,548.

An element containing an image-yielding, nonblocking photopolymerizable stratum on a strippable support is preferably used such as the one described in U.S. Patent 4,293,635.

Alternatively, particularly if the photopolymerizable layer is tacky, the remaining surface of the supported, photopolymerizable stratum may be protected by a removable cover sheet or when the element is stored in roll form, the stratum surface may be protected by the contiguous reverse surface of the support. The photosensitive composition is present in a dry coating thickness of about 0.0003 inch (0.0008 cm) to about 0.01 inch (0.025 cm) or more. A suitable strippable support which preferably has a high degree of dimensional stability to temperature changes, may be chosen from a wide variety of films composed of high polymers, e.g., polyamides, polyolefins, polyesters, vinyl polymers, and cellulose esters, and may have a thickness of from 0.00025 inch (0.0006 cm) to 0.008 inch (0.02 cm) or more. If exposure is to be made before removing the strippable support, it must, of course, transmit a substantial fraction of the actinic radiation incident upon it. If the strippable support is removed prior to

3

exposure, no such restrictions apply. A particularly suitable support is a transparent polyethylene terephthalate film having a thickness of about 0.001 inch (0.0025 cm).

When the element contains no removable, protective cover sheet and is to be stored in roll form, additional protection against blocking can optionally be provided if the reverse side of the strippable support preferably has applied thereto a thin release layer of a material, such as wax or silicone, to prevent blocking with the photopolymerizable stratum. Alternatively, adhesion to the coated photopolymerizable layer may be preferentially increased by flame treating or electrical discharge treating the support surface to be coated.

Suitable removable, protective cover sheets when used may be chosen from the same group of high polymer films described above and may have the same wide range of thicknesses. A cover sheet of 0.001 inch (0.0025 cm) thick polyethylene is especially suitable. Supports and cover sheets as described above provide good protection to the photopolymerizable resist layer.

When the invention is used in applications in which very rapid adhesion is needed, for example, the self-trimming process disclosed in EP—A—41 642, it is essential that the adhesion $(A_1)$ of the unexposed photosensitive layer to the polymeric support exceed the breaking strength (B) of the unsupported photosensitive layer. Likewise, the adhesion $(A_2)$ of the unexposed photosensitive layer to the substrate must exceed the breaking strength (B) of the unsupported photosensitive layer. In addition, since the polymeric support must be strippable from the laminated photopolymerizable layer, the adhesion $(A_2)$ of the photolayer to the substrate must also exceed its adhesion $(A_1)$ to the polymeric support. Expressed mathematically, $A_2>A_1>B$.

The photohardenable layer is prepared from polymeric components (binders), monomeric components, initiators and inhibitors.

Suitable binders which can be used as the sole binder or in combination with others include the following: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers; polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides, e.g., N-methoxymethyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose; polycarbonates; polyvinyl acetal e.g., polyvinyl butyral, polyvinyl formal; polyformaldehydes.

Preferably, the binder should contain sufficient acidic or other groups to render the composition processible in aqueous developer. Useful aqueous-processible binders include those disclosed in U.S. Patent 3,458,311 and in U.K. Patent 1,507,704. Useful amphoteric polymers include interpolymers derived from N-alkylacrylamides or methacrylamides, acidic film-forming comonomer and an alkyl or hydroxyalkyl acrylate such as those disclosed in U.S. Patent 3,927,199.

Suitable monomers which can be used as the sole monomer or in combination with others include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, poloxyethylated trimethylolpropane triacrylated and trimethacrylate and similar compounds as disclosed in U.S. Patent 3,380,831, 2,2-di(p-hydroxhphenyl)-propane diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-acryloxyethyl) ether of bisphenol-A, di-(3-methacryloxy-2-hydroxypropyl) etherof bisphenol-A, di-(2-acryloxythyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylenically unsaturated monomers mentioned above, the photohardenable layer can also contain at least one of the following free radical-initiated, chain-propagating, addition-polymerizable, ethylenically unsaturated compounds having a molecular weight of at least 300. Preferred monomers of this type are an alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such materials wherein the ethylenically unsaturated groups, especially the vinylidene groups are conjugated with ester or amide structures.

Preferred free radical-generating addition polymerization initiators activatable by actinic light and thermally inactive at and below 185°C include the substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethyl-anthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione. Other photoinitiators which are also useful, even though some may be thermally active at temperatures as low as 85°C, are described in U.S. Patent 2,760,863 and include vicinal ketaldonyl alcohols, such as benzoin, pivaloin, acyloin ethers, e.g. benzoin methyl and ethyl ethers; $\alpha$-hydrocarbon-substituted aromatic acyloins, including $\alpha$-methylbenzoin, $\alpha$-allylbenzoin and $\alpha$-phenylbenzoin. Photoreducible dyes and reducing agents disclosed in U.S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenyl-imidazolyl dimers with hydrogen donors, and mixtures thereof as described in U.S. Patents: 3,427,161 3,479,185; and 3,549,367 can be used as initiators. Also useful with photoinitiators and photo-inhibitors are sensitizers disclosed in U.S. Patent 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibition are the nitroso compositions disclosed in U.S. Patent 4,168,982.

Various dyes and pigments may be added to increase the visibility of the resist image. Any colorant used, however, should preferably be transparent to the actinic radiation used.

Generally, suitable substrates for the process of the invention involving printed circuit formation are those which have mechanical strength, chemical resistance and good dielectric properties. Thus, most board materials for printed circuits are thermosetting or thermoplastic resins usually combined with a reinforcing filler. Thermosetting resins with reinforcing fillers are ordinarily used for rigid boards, whereas thermoplastic resin without reinforcements are usually used for flexible circuit boards. Ceramic and dielectric-coated metals are also useful. The materials from which the board is made may, of course, influence the choice of liquid for the thin layer.

Typical board construction involves combinations such as phenolic or epoxy resins on paper or a paper-glass composite, as well as polyester, epoxy, polyimide, polytetrafluorethylene, or polystyrene on glass. In most instances, the board is clad with a thin layer of electroconductive metal of which copper is by far the most common.

Suitable substrates for the process of the invention involving preparation of lithographic printing plates are those which have mechanical strength and surfaces which differ in hydrophilicity or oleophilicity from the surfaces of the imaged photosensitive areas laminated thereto. Such substrates are disclosed in U.S. Patent 4,072,528. While numerous substrates are satisfactory for this purpose thin anodized aluminum plates such as disclosed in U.S. Patent 3,458,311 are particularly useful.

As noted above, the adhesion of the unexposed photosensitive layer to substrates such as copper or aluminum ($A_2$) must be greater than its adhesion to the support ($A_1$). A high value for $A_2$ is also needed for many of the applications of this invention where the photoresist layer must remain adhered to the substrate during exposure to severe chemical or mechanical conditions.

It will be recognized by those skilled in the art that it will be preferable for the printed circuit substrate surface which is to be laminated to be clean and free of any extraneous material which might

5

render any significant amount of the surface nonwettable. For this reason, it will frequently be desired to clean printed circuit substrates prior to lamination by one or more of the several cleaning processes which are well-known in the field of printed circuit board manufacture. The particular type of cleaning depends upon the type of contamination—organic, particulate or metallic. Such methods include degreasing with solvents and solvent emusions, mechanical scrubbing, alkaline soaks, acidification and the like, followed by rinsing and drying.

The invention will be more clearly understood by reference to the following examples and the detailed description of the Drawing hereinbelow.

Example I

Resist properties

A roll of photoresist film having no cover sheet is prepared as follows:

A photosensitive coating solution is prepared having the following composition:

| Component | Parts by weight |
|---|---|
| (a) 1:1 Copolymer of styrene and maleic anhydride partially esterified with isobutyl alcohol; mol. wt. ca. 20,000; acid number ca. 180 | 40 |
| (b) Terpolymer of 17% ethyl acrylate, 71% methyl methacrylate, and 12% acrylic acid; mol. wt. ca. 300,000; acid number ca. 105 | 12.6 |
| (c) Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 5 |
| (d) Polyoxyethylated trimethylolpropane triacrylate (20 moles of ethylene oxide) (M.W. 1162) | 10 |
| (e) Trimethylolpropane triacrylate | 12.5 |
| (f) Benzophenone | 4 |
| (g) 4,4'-Bis(dimethylamino) benzophenone (Michler's ketone) | 0.7 |
| (h) 2,2'-Bis(2-chlorophenyl)-4,4',5,5'-tetraphenyl biimidazole | 3 |
| (i) Leuco crystal violet | 0.4 |
| (j) Benzotriazole | 0.2 |
| (k) 1,4,4-Trimethyl-2,3,-diazobicyclo-[3.2.2]-non-2-ene-2,3-dioxide | 0.06 |
| (l) Victoria Green (C.I. Pigment Green 18) | 0.03 |
| (m) Methylene chloride | 200 |
| (n) Methanol | 15 |

J.F. 842 (8433) T T4

Into the above coating solution are dispersed 13 parts by weight of polyethylene beads of which 85% have diameters below 10 $\mu$m and 15% have diameters between 10 and 20 $\mu$m. The mixture is coated on a 0.00127 cm thick poly(ethylene terephthalate) web which has coated on its reverse side a thin layer of a mixture of Carnuba wax and poly(vinylidene chloride). The photopolymerizable layer is dired to give a dry thickness of 0.00254 cm and about 30.5 meters of the dried coated element is wound into a roll.

Detailed description of the drawing

Turning now to the drawing, each member of a series of substrates for printed circuits 1 is mechanically advanced in a continuous manner on a roller conveyor through cleaning chamber 3 in which both the upper and lower copper-clad surfaces thereof are cleaned by mechanically scrubbing under a heavy water spray. The boards are made of fiberglass-reinforced epoxy resin. The substrate boards, which are clean as defined by the uniform water film test, are further advanced through alignment rolls 5 by which the sides of the boards are precisely aligned. From the alignment rolls 5, each aligned board emerges and is passed between steam chambers 7 into which low pressure steam is admitted via line 8. The steam emerging from the open ends of the steam chambers 7 condenses in part, thus forming a thin layer of water on both the exposed upper and lower surfaces of the substrate boards. The water films have a thickness of 10 to 50 $\mu$m. The board with both surfaces coated with a thin layer of water is then advanced to a set of upper and lower feed rolls 9 each of which places the unprotected surface of the photosensitive layer of the continuous resist film 11 from Example I against the thin layer. The feed rolls 9 are mechanically linked with the mechanism used for advancing the boards 1 in such manner that the boards are butted up against one another as they enter the feed rolls 9 and there is no significant amount of bridging by the film 11 between the trailing and leading edges of each board. The laminating film prepared as described in Example I is supplied from supply roll 12. The abutting boards 1 with the film resist 11 in place is then advanced through the nips of heated laminating rolls 13 in which the film layers 11 are subjected to both pressure and heat, by which the thin water layer on the photosensitive layer is removed from the substrate mainly by absorption into the photosensitive layer. The temperature of the laminating roll surfaces is about 109°C and the linear speed of the boards through the laminator is about 182,88 cm per minute. Minor amounts of water are removed by evaporation. Lamination is completed within about 40 seconds after the board is cleaned.

The laminated boards 1 still abutting each other, are advanced at a uniform rate between wedges 15. At the exit of the wedges 15, the polyethylene terephthalate web 17 on the outer surface of the continuous film is pulled back uniformly from the substrate at an obtuse angle (here 150°) which causes the photosensitive layer to be trimmed in a straight line along the leading edge of the board 1). The web 17 is pulled back by the action of take-up rolls 19 and the advancing action of the board. As the substrate board 1 emerges from between wedges 15 progressively more of the photosensitive layer is uncovered until the board advances to and is grasped firmly at the sides between a pair of clutch-driven rapidly rotating trimming rolls 21 (only one is shown) which rotate at a speed faster than the linear speed of the advancing board until they grasp the panel sides. The trimming rolls then move with the linear speed of the board by means of a slip clutch which compensates for the difference in driving speeds. The trimming rolls 21 place a transverse tensile stress on the board which causes the thermoplastic layer to be trimmed smoothly along the trailing edge of the board as it emerges from between the wedges 15. When the trailing edge trimming is completed, thus separating the leading and trailing boards in the series, the laminated board is ready for circuit preparation by conventional photoresist techniques.

In a preferred aspect, the process is simultaneously practiced on both sides of the succession of substrates so that photopolymerizable layer is laminated to both sides of the substrates. In this instance, it is especially important that no liquid be present in the holes in the substrate, lest the heat of lamination vaporize the liquid and cause the "tents" of photosensitive layer over the holes in the substrate to expand and burst. It is also preferred that the succession of substrates be close enough that the spring-loaded lamination rolls normally used for lamination do not "bottom" between substrates. This avoids bonding together of the two photopolymerizable layers extending between the successive substrates, that is the "hinges" between successive substrates, since such bonding is likely to interfere with self-trimming of the leading edge when the support films are removed. Alternatively, the pressure on the lamination rolls can be reduced to minimize bonding of the layers. It is preferred, however, that "hinging" itself be kept to a minimum to facilitate the self-trimming function.

Though the process of the invention as described above is carried out continuously, it will be recognized that the process can also be conducted intermittently as well.

Example II

Mist application of thin layer

Two substrates (1,6 mm and 0,8 mm thickness) made of fiberglass-reinforced epoxy resin and copper clad on both sides are cleaned by mechanically scrubbing them in a heavy spray of water. The surfaces of the cleaned dry boards are then wetted with finely divided droplets of water by means of an air brush powered by a pressurized aerosol can. Uniform wetting is obtained which is fully comparable to the wetting obtained by the above-described process in which wetting is achieved by condensation of steam. Excellent lamination is obtained when the boards are laminated with the film of Example I, as described above, using hot nip rolls at a roll surface temperature of 109°C.

Example III

Comparison with liquid application

Each of several boards of the type described in the previous examples which has not been cleaned, are coated with a water film prepared by steam condensation, water mist spray or by wiping with a water saturated tissue.

The films applied in these ways are then examined microscopically and measured. The thin layers applied by steam condensation or misting are comprised of uniformly small sized droplets and subsequently hot roll lamination of the resist of Example I, as described above, thereto gives quite excellent adhesion with no discernible occlusions or discontinuities. On the other hand, the layer applied directly as a liquid does not uniformly cover the substrate and is comprised mainly of large drops having an average diameter of over 500 $\mu$m. Moreover, when the boards with the film made in this manner are laminated in the same manner as previously described boards, uniform lamination is not obtained when tested by the tape delamination test.

In the above-referred tape delamination test, a 15,24 cm length of 2,54 cm wide Scotch® brand black poly/paper masking tape is firmly applied to the laminated photosensitive surface and then one edge is pulled away from the surface. Lamination is unsatisfactory if any of the photosensitive layer is pulled off with the tape.

Example IV

Mist application with a solution

Example II is repeated except that instead of water a dilute aqueous solution of benzotriazole hydrochloride is used in the air brush to form the finely divided droplets with similar excellent lamination.

7

Example V
Preparation of a lithographic printing plate

A photosensitive coating mixture was prepared, coated, and laminated as in Example I except that instead of the beads used therein, 16 parts by weight of 1 micrometer polyethylene beads (Microfine VIII—F. Gold, tradename of Dura Commodities Corporation, Harrison, NY) were dispersed in the coating solution. The surface of a 0.023 cm thick aluminum plate was scrubbed with tungsten carbide brushes in water using a Chemcut® Model 107 (tradename of Chemcut Corporation, State College, PA) Mechanical Cleaning System and the scrubbed surface was laminated to the photosensitive layer and the layer trimmed as described in Example I.

The laminated and trimmed board was imaged by exposing for 60 seconds the photosensitive layer through a halftone and line transparency to U.V. radiation from a 2000 watt pulsed Xenon arc light source in a flip top platemaker. The unexposed areas were completely removed by development in a 1% aqueous solution of sodium carbonate to provide a halftone polymeric image with complimentary image areas of bare aluminum surface. The resulting lithographic printing plate was conventionally gummed with Lydex® Finishing solution (LDFS) (tradename of E.I. du Pont de Nemours and Company, Wilmington, DE) and mounted on an A. B. Dick Model 380 offset printing press. Using standard inking and fountain solutions, at least 3500 copies of good quality were obtained from the printing plate.

## Claims

1. In a process for laminating a supported photosensitive layer to a substrate surface by means of pressure, the improvement comprising the sequential steps of:

(a) forming a thin layer of liquid on the substrate surface immediately prior to lamination by contacting the surface at a temperature below the condensation point of the liquid with a vapor derived from the liquid or with a gaseous dispersion of finely divided liquid particles, which layer forms an interface between the substrate surface and the photosensitive layer upon lamination; and
(b) displacing the thin layer of liquid from the substrate surface by absorption into the photosensitive layer during lamination.

2. The process of claim 1 in which the liquid is aqueous.

3. The process of claim 1 in which the lamination is conducted by means of heated nip rolls.

4. The process of claim 1 in which the thin liquid layer is formed by contacting the substrate surface with water which is applied as steam near its dew point or as a mist having very fine water particles, the temperature of the substrate surface being below the dew point of the steam.

5. The process of claim 1 in which the liquid is selected from the group consisting of water, $C_{1-4}$ alkanols and aqueous solutions of $C_{1-14}$ alkanols.

6. The process of claim 5 in which the liquid has a nitrogen containing heterocyclic compound dissolved therein.

7. The process of claim 1 in which the thin layer is derived from a gaseous dispersion of finely divided liquid particles having solids dispersed therein.

8. The process of claim 7 in which the solids are dissolved in the liquid.

9. The process of claim 1 in which the liquid is a nonsolvent with respect to the thermoplastic layer.

10. The process of claim 1 in which the surface has been chemically and/or mechanically cleaned immediately prior to lamination.

11. The process of claim 10 in which the surface has been mechanically cleaned by brushing in water.

12. The process of claim 1 in which the surface has been cleaned by means of an oxide removing agent.

13. The process of claim 1 in which the substrate surface is a metal selected from the group consisting of copper, aluminum, brass, steel, chemical milling alloys and mixtures thereof.

14. The process of claim 1 in which the substrate surface is a ceramic or dielectric material.

## Patentansprüche

1. Verfahren zur Laminierung einer trägerunterstützten lichtempfindlichen Schicht auf ein Substrat mittels Druck, gekennzeichnet durch die aufeinander folgenden Schritte:

(a) Herstellen einer dünnen Flüssigkeitsschicht auf der Substrat-Oberfläche unmittelbar von der Laminierung durch In-Berührung-Bringen der Oberfläche bei einer Temperatur unterhalb des Kondensationspunktes der Flüssigkeit mit einem sich von der Flüssigkeit ableitenden Dampf oder mit einer gasförmigen Dispersion feinteiliger Flüssigkeitsteilchen, wobei diese Flüssigkeitsschicht nach der Laminierung eine Grenzfläche zwischen der Substrat-Oberfläche und der lichtempfindlichen Schicht bildet; und

(b) Verschiebung der dünnen Flüssigkeitsschicht von der Substratoberfläche durch Absorption in die lichtempfindliche Schicht hinein während der Laminierung.

2. Verfahren nach Anspruch 1, dadurch gekennzeichnet, daß die Flüssigkeit wäßrig ist.

3. Verfahren nach Anspruch 1, dadurch gekennzeichnet, daß die Laminierung mittels beheizter Quetschwalzen durchgeführt wird.

4. Verfahren nach Anspruch 1, dadurch gekennzeichnet, daß die dünne Flüssigkeitsschicht dadurch hergestellt wird, daß die Substrat-Oberfläche mit Wasser in Berührung gebracht wird, das als Dampf in der Nähe seines Taupunktes oder als Nebel mit sehr feinen Wasser-Teilchen aufgebracht wird, wobei die Temperatur der Substrat-Oberfläche unterhalb des Taupunktes des Dampfes liegt.

5. Verfahren nach Anspruch 1, dadurch gekennzeichnet, daß die Flüssigkeit ausgewählt ist aus der aus Wasser, $C_{1-4}$-Alkanolen sowie wäßrigen Lösungen von $C_{1-14}$-Alkanolen bestehenden Gruppe.

6. Verfahren nach Anspruch 5, dadurch gekennzeichnet, daß die Flüssigkeit eine Stickstoff enthaltende heterocyclische Verbindung in gelöster Form enthält.

7. Verfahren nach Anspruch 1, dadurch gekennzeichnet, daß die dünne Schicht sich ableitet von einer gasförmigen Dispersion feinteiliger Flüssigkeitsteilchen mit darin dispergierten Feststoffen.

8. Verfahren nach Anspruch 7, dadurch gekennzeichnet, daß die Feststoffe in der Flüssigkeit gelöst sind.

9. Verfahren nach Anspruch 1, dadurch gekennzeichnet, daß die Flüssigkeit ein Nicht-Lösungsmittel in bezug auf die thermoplastische Schicht ist.

10. Verfahren nach Anspruch 1, dadurch gekennzeichnet, daß die Oberfläche unmittelbar vor der Laminierung chemisch und/oder mechanisch gereinigt worden ist.

11. Verfahren nach Anspruch 10, dadurch gekennzeichnet, daß die Oberfläche durch Bürsten in Wasser mechanisch gereinigt worden ist.

12. Verfahren nach Anspruch 1, dadurch gekennzeichnet, daß die Oberfläche mit Hilfe eines Oxid(e) entfernenden Mittels gereinigt worden ist.

13. Verfahren nach Anspruch 1, dadurch gekennzeichnet, daß die Substrat-Oberfläche aus einem Metall ausgewählt aus der aus Kupfer, Aluminium, Messing, Stahl, chemischen Walzlegierungen (milling alloys) und Mischungen aus diesen bestehenden Gruppe besteht.

14. Verfahren nach Anspruch 1, dadurch gekennzeichnet, daß die Substrat-Oberfläche aus einem keramischen oder dielektrischen Material besteht.

**Revendications**

1. Dans un procédé de stratification d'une couche photosensible supportée, sur une surface du substrat au moyen de pression, le perfectionnement comprenant les étapes successives selon lesquelles:

(a) on forme une couche mince de liquide sur la surface du substrat immédiatement avant la stratification en mettant en contact la surface à une température au-dessous du point de condensation du liquide avec une vapeur dérivée du liquide ou avec une dispersion gazeuse de particules liquides finement divisées, cette couche formant une interface entre la surface du substrat et la couche photosensible lors de la stratification; et

(b) on déplace la couche mince de liquide de la surface du substrat par absorption dans la couche photosensible durant la stratification.

2. Un procédé selon la revendication 1, dans lequel le liquide est aqueux.

3. Un procédé selon la revendication 1, dans lequel la stratification est effectuée au moyen de rouleaux presseurs chauffés.

4. Un procédé selon la revendication 1, dans lequel la couche mince de liquide est formée par mise en contact de la surface du substrat avec de l'eau qui est appliquée sous la forme de vapeur près de sont point de rosée ou sous la forme d'un brouillard ayant de très fines particules d'eau, la température de la surface du substrat étant au-dessous du point de rosée de la vapeur d'eau.

5. Un procédé selon la revendication 1, dans lequel le liquide est choisi parmi l'eau, les alcanols en $C_{1-4}$ et les solutions aqueuses d'alcanols en $C_{1-14}$.

6. Un procédé selon la revendication 5, dans lequel le liquide contient à l'état dissous un composé hétérocyclique azoté.

7. Un procédé selon la revendication 1, dans lequel la couche mince dérive d'une dispersion aqueuse de particules liquides finement divisées contenant des matières solides dispersées.

8. Un procédé selon la revendication 7, dans lequel les matières solides sont dissoutes dans le liquide.

9. Un procédé selon la revendication 1, dans lequel le liquide est un non-solvant eu égard à la couche thermoplastique.

10. Un procédé selon la revendication 1, dans lequel la surface a été nettoyée chimiquement et/ou mécaniquement immédiatement avant la stratification.

11. Un procédé selon la revendication 10, dans lequel la surface a été nettoyée mécaniquement par brossage dans l'eau.

12. Un procédé selon la revendication 1, dans lequel la surface a été nettoyée au moyen d'un agent enlevant les oxydes.

13. Un procédé selon la revendication 1, dans lequel la surface du substrat est un métal choisi parmi le cuivre, l'aluminium, le laiton, l'acier, des alliages pour usinage chimique et leurs mélanges.

14. Un procédé selon la revendication 1, dans lequel la surface du substrat est une matière céramique ou diélectrique.